# EUROPEAN PATENT SPECIFICATION

(11) **EP 2 747 148 B1**
(45) Date of publication and mention of the grant of the patent: **04.11.2015**
(21) Application number: 13198844.6
(22) Date of filing: 20.12.2013
(51) Int. Cl.: H01L 31/032, H01L 31/0749, H01L 31/18, H01L 21/02

(54) **Method for fabricating an absorbing layer of a solar cell and a thermal treatment apparatus thereof**
Verfahren zur Herstellung einer Absorptionsschicht einer Solarzelle und eine Wärmebehandlungsvorrichtung dafür
Procédé de fabrication de couche absorbante de cellule solaire et dispositif de traitement thermique de celui-ci

(30) Priority: 21.12.2012 TW 101149186; 22.11.2013 TW 102142626
(43) Date of publication of application: 25.06.2014
(73) Proprietor: Industrial Technology Research Institute, Chu-Tung, Hsinchu (TW)
(72) Inventor: Wu, Tsung-Shin, Zhubei City, Hsinchu County (TW); Wu, Shih-Hsiung, Tainan City (TW); Chang, Chia-Wen, New Taipei City (TW); Hsu, Hung-Ru, Changhua City, Changhua County (TW)
(74) Representative: Viering, Jentschura & Partner Patent- und Rechtsanwälte

(56) References cited:
- WO-A2-2007/101136
- US-A1- 2012 190 180
- US-A1- 2012 193 349

## Description

### Technical Field

The disclosure relates to a method for fabricating an absorbing layer of a solar cell and a thermal treatment device thereof.

### Background

As environmental issues become more and more important, the exploitation of green power has become an important issue in all fields. Solar energy, which is easily captured, has no pollution, is highly safe, renewable, and has increasingly been used in recent years for power generation.

Currently, mainstreaming solar cells adopt the composition of group XI elements-group XIII elements - group XVI elements, for example, taking copper-indium-selenium (CIS) or copper-indium-gallium-selenium (CIGS) as absorbing layers. However, rare elements, such as indium (In) and gallium (Ga), which belong to group XIII elements, are employed in the absorbing layers so that the production cost of the solar cell is greatly increased. Therefore, in order to decrease the production cost, absorbing layers which do not contain indium or gallium have been used. For example, solar cells adopting the composition of group XI elements - group XII elements - group XIV elements - group XVI elements, for example, copper-zinc-tin-sulfur (CZTS), copper-zinc-tin-selenium (CZTSe) or copper-zinc-tin-sulfur-selenium (CZTSSe) have been used as the absorbing layer of the solar cell.

As for the CZTS, the crystal form of the CZTS that can be used as the absorbing layer of the solar cell is Kesterite form. The crystal form of the CZTS may vary according to the proportions of the element compositions of the absorbing layer. Therefore, during the fabrication of the absorbing layer, each proportion of copper, zinc, tin and sulfur needs to be consistent before and after the fabrication process so as to avoid the formation of other crystal forms. Furthermore, when the element effuses from the absorbing layer during the heating process of the fabrication of the solar cell, the CZTS may transform into other crystal forms, for example, Stannite form. When other crystal forms are formed in the absorbing layer of the solar cell, the transformation efficiency of the solar cell is lowered or completely lost because of the corresponding high resistance, low carrier concentration or the absence of the photoelectric effect of the absorbing layer of the solar cell. The Kesterite form and the Stannite form may co-exist or mutually transform during the fabrication process, and the Stannite form does not generate the photoelectric effect. Therefore, when the Stannite form is formed in the CZTS absorbing layer, the transformation efficiency of the fabricated solar cell is lowered.

In brief, it is important to design a method for fabricating an absorbing layer of a solar cell and a thermal treatment device thereof so as to solve the problem that different crystal forms are generated due to the effusion of the element in the absorbing layer during the fabrication process of the solar cell.

Reference is likewise made to the prior art documents US2012190180, US2012193349 and WO2007101136. 15

### SUMMARY

The current invention is related to a method for fabricating an absorbing layer of a solar cell according to the independent method claim 1 and to a thermal treatment device used for performing a thermal treatment on an absorbing layer precursor on a substrate of a solar cell according to the independent device claim 15.

### BRIEF DESCRIPTION OF THE DRAWINGS

The present disclosure will become more fully understood from the detailed description given hereinbelow, along with the accompanying drawings which are for illustration only, thus are not limitative of the present disclosure, and wherein:
FIG. 1A is a schematic side view of a thermal treatment device;
FIG. 1B is a top view of the solid-phase vapor source in FIG. 1A;
FIG. 1C is a top view of a solid-phase vapor source;
FIGs. 1D-1F are schematic side views of a thermal treatment device;
FIG. 2 is a flow chart of a method for fabricating an absorbing layer of a solar cell ;
FIG. 3 is a top view of the thermal treatment device in FIG. 1A before a solid-phase vapor source is disposed;
FIG. 4 is a top view of the thermal treatment device in FIG. 1A;
FIGs. 5A-5F are schematic side views of a thermal treatment device;
FIGs. 6A-6C are schematic side views of a thermal treatment device;
FIG. 7A and 7B are flow charts of a method for fabricating an absorbing layer of a solar cell;
FIG. 8A is a view of a result of scanning electron microscopic analysis of an absorbing layer fabricated according to the method of FIG. 7A; and
FIG. 8B is a view of a result of scanning electron microscopic analysis of stannic sulfide deposited on an absorbing layer.

### DETAILED DESCRIPTION

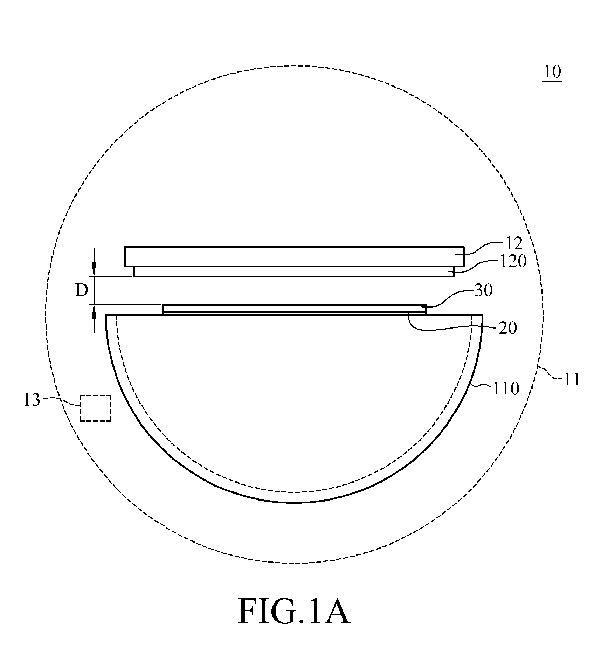

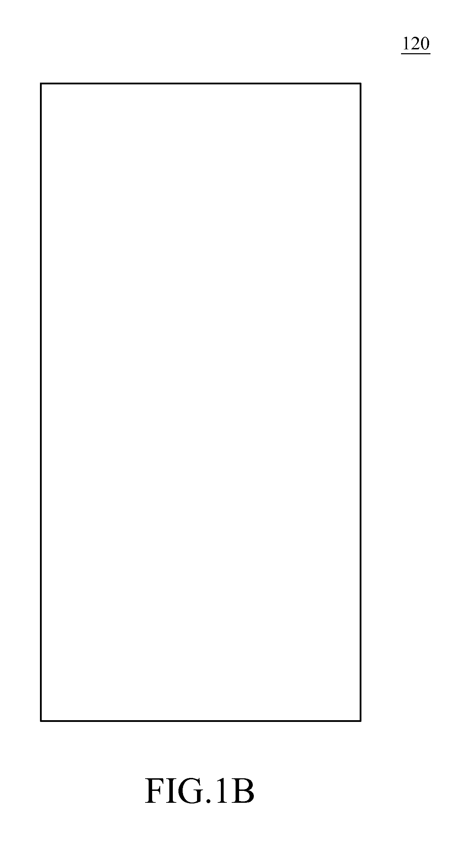

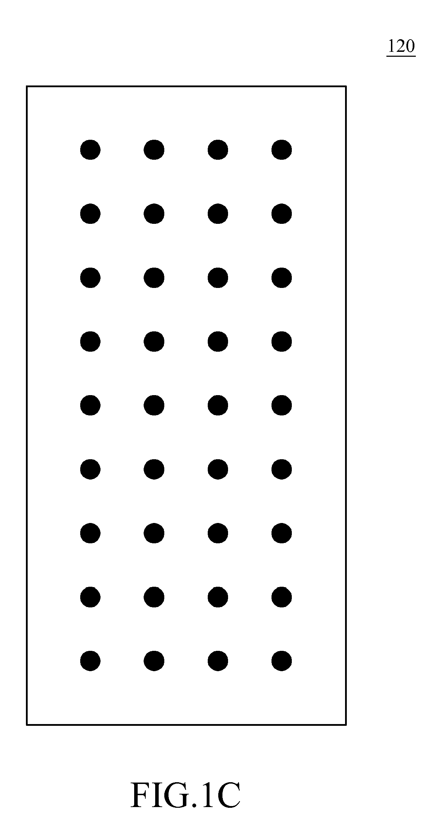

First, please refer to FIGs. 1A-1C. FIG. 1A is a schematic side view of a thermal treatment device. FIG. 1B is a top view of the solid-phase vapor source in FIG. 1A. FIG. 1C is a top view of a solid-phase vapor source. A thermal treatment device 10 is used for performing a thermal treatment on an absorbing layer precursor 30 on a substrate 20 of a solar cell. The substrate 20 is made of, for example, titanium, platinum, ceramic or quartz, so as to prevent the substrate 20 from being deteriorated during the fabrication of an absorbing layer of the solar cell. The absorbing layer precursor 30 is, for example, an absorbing layer precursor containing copper, zinc, tin and sulfur, but the disclosure is not limited thereto. In other examples, the absorbing layer precursor 30 is an absorbing layer precursor containing copper, zinc, tin, sulfur and selenium. In the following descriptions, the absorbing layer precursors containing copper, zinc, tin and sulfur are described.

The thermal treatment device 10 comprises a chamber 11, a carrier 12 and a temperature controller 13. The chamber has a base 110. The substrate 20 is disposed on the base 110. The chamber 11 is an open chamber or a half-open chamber. The chamber 11 is a non-oxygen environment (i.e, an environment without any oxygen) so as to prevent the composition of the absorbing layer precursor 30 from being oxidized by oxygen. For instance, the chamber 11 is filled with argon or nitrogen. Also, the pressure in the chamber 11 is negative pressure or equal to the external pressure.

The carrier 12 is disposed in the chamber 11. The carrier 12 faces both the substrate 20 and the absorbing layer precursor 30. A solid-phase vapor source 120 is disposed on the carrier 12. In detail, the solid-phase vapor source 120 is loaded on the carrier 12 by coating, chemical plating, sputtering or evaporation. A predetermined distance D is maintained between the solid-phase vapor source 120 and the absorbing layer precursor 30. The predetermined distance D is between 0.1 cm and 4 cm. In some other examples, the predetermined distance D is between 0.1 cm and 2 cm. In this and some other examples the solid-phase vapor source 120 is, for example, a planar solid-phase vapor source (as shown in FIG. 1B) or an array of dot-shaped solid-phase vapor source (as shown in FIG. 1C), but the disclosure is not limited thereto. Therefore, each section of the absorbing layer precursor 30 and the solid-phase vapor source 120 are kept by the predetermined distance D.

In this example, the solid-phase vapor source 120 contains tin. Therefore, during the thermal treatment, the solid-phase vapor source 120 vaporizes and transforms to a vapor containing tin. Since the solid-phase vapor source 120 and the absorbing layer precursor 30 are kept by the predetermined distance D, a kinetic equilibrium of the tin between the vapor transformed from the solid-phase vapor source 120 and the absorbing layer precursor 30 is achieved. When the tin effuses from the absorbing layer precursor 30, the tin in the vapor is capable of compensating for the effusion of the tin from the absorbing layer precursor 30, so that the tin effusing from the absorbing layer precursor 30 is inhibited or even avoided. Thus, the proportion of tin in the absorbing layer formed from the absorbing layer precursor 30 is maintained. In other words, the solid-phase vapor source 120 is capable of maintaining the proportion of tin in the absorbing layer, which is formed from the absorbing layer precursor 30, so that the absorbing layer remains to be single Kesterite form.

In this and some other example, the predetermined distance D kept between the solid-phase vapor source 120 and the absorbing layer precursor 30 affects the proportion of tin in the absorbing layer formed from the absorbing layer precursor 30. Also, the predetermined distance D affects which crystal form the absorbing layer is. When the predetermined distance D is shorter, the inhibition of the effusion of the tin of the absorbing layer precursor 30 by the solid-phase vapor source 120 is enhanced and the proportion of tin in the absorbing layer is well maintained, as well as the tin of the absorbing layer is more evenly distributed However, when the solid-phase vapor source 120 is attached to the absorbing layer precursor 30, the solid-phase vapor source 120 weakens the structure of the absorbing layer formed from the absorbing layer precursor 30, so that the fabricated solar cell is undesirable.

In the above examples, the solid-phase vapor source 120 is adapted for maintaining the proportion of tin in the formed absorbing layer. In some other examples, the solid-phase vapor source 120 further contains sulfur, so that the vapor formed from the solid-phase vapor source 120 further contains sulfur. Therefore, the solid-phase vapor source 120 is also adapted for inhibiting or even preventing the sulfur from effusing from the absorbing layer precursor 30. Furthermore, the proportion of sulfur in the absorbing layer formed from the absorbing layer precursor 30 is maintained. Similarly, in the examples that the absorbing layer precursor 30 contains copper, zinc, tin, sulfur and selenium, the solid-phase vapor source 120 further contains selenium. Therefore, the solid-phase vapor source 120 is adapted for inhibiting or even preventing the selenium from effusing from the absorbing layer precursor 30. Furthermore, the proportion of selenium in the absorbing layer formed from the absorbing layer precursor 30 is maintained.

In this example, for example, the solid-phase vapor source 120 is stannic sulfide, stannous sulfide, stannic selenide, stannous selenide or combinations thereof.

The temperature controller 13 is assembled in the chamber 11. The temperature controller 13 is adapted for adjusting the temperature in the chamber 11, i.e. raising, lowering or maintaining the temperature in the first chamber 41.

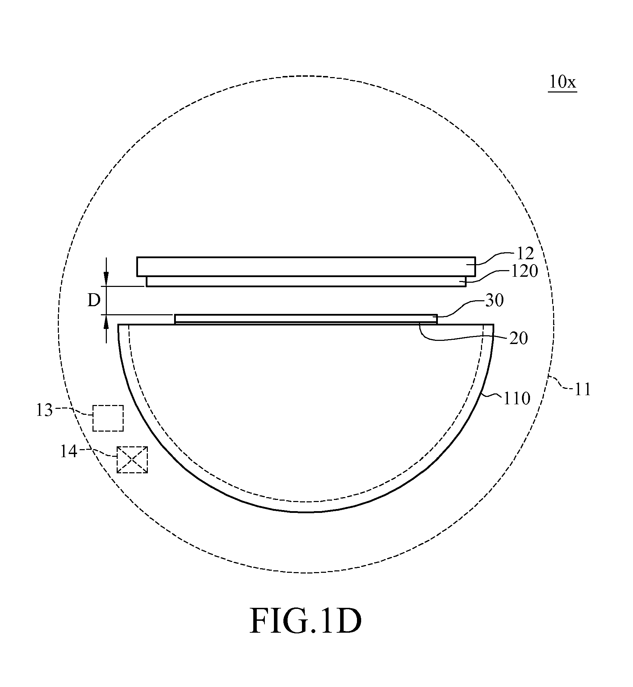

Please refer to FIGs. 1D-1F, FIGs. 1D-1F are schematic side views of a thermal treatment device.

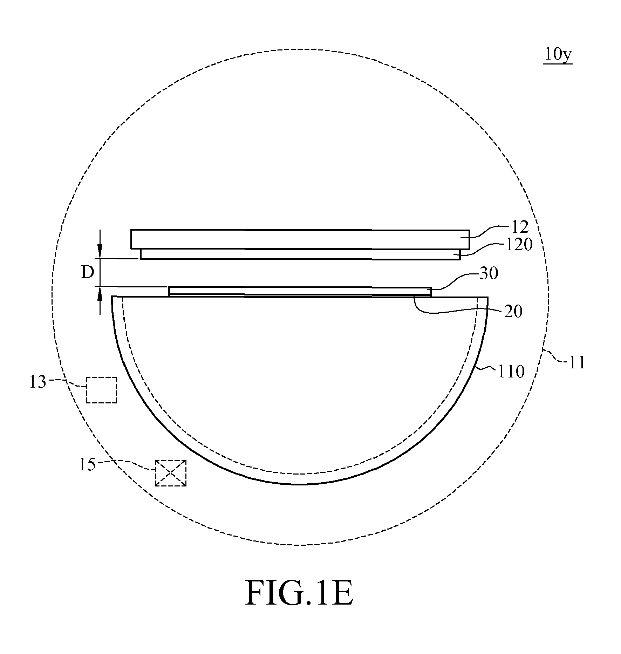

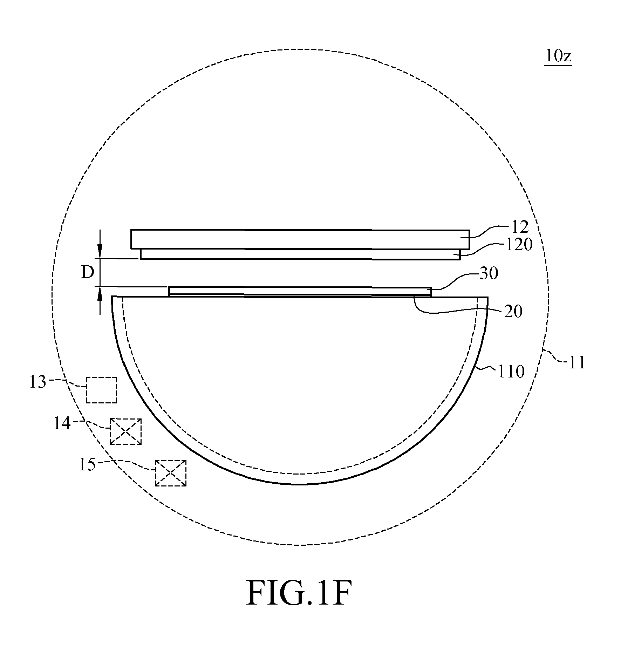

In FIG. 1D, the thermal treatment device 10x further comprises a first gas supply 14. The first gas supply 14 is disposed in the chamber 11. The first gas supply 14 is adapted for providing a first gas to the chamber 11. The first gas is sulfur vapor, selenium vapor, hydrogen sulfide, hydrogen selenide or combinations thereof. Thereby, the first gas is adapted for maintaining the proportion of the elements in the absorbing layer formed from the absorbing layer precursor 30. In FIG. 1E, the thermal treatment device 10y further comprises a second gas supply 15. The second gas supply 15 is disposed in the chamber 11. The second gas supply 15 is adapted for providing a second gas to the chamber 11. The second gas is stannic sulfide, stannous sulfide, stannic selenide, stannous selenide or combinations thereof. Thereby, the second gas is adapted for maintaining the proportion of the elements in the absorbing layer formed from the absorbing layer precursor 30. In FIG. 1F, the thermal treatment device 10z further comprises a first gas supply 14 and a second gas supply 15 so as to maintain the proportion of the elements in the absorbing layer formed from the absorbing layer precursor 30.

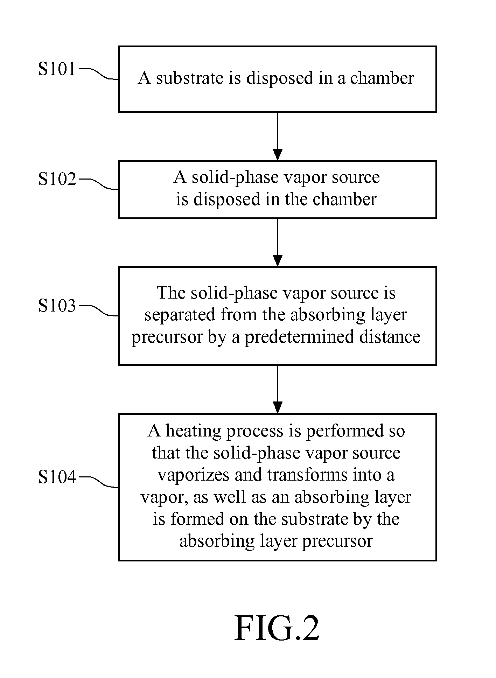

Then, please refer to FIG. 2, which is a flow chart of a method for fabricating an absorbing layer of a solar cell.

First, a substrate is disposed in a chamber (Step S101). For example, the material of the substrate is titanium, platinum, ceramics or quartz, which avoids the deterioration of the substrate under a high temperature during the fabrication of the absorbing layer of the solar cell. An absorbing layer precursor is loaded on the substrate. The method for loading the absorbing layer precursor on the substrate comprises coating, chemical plating, sputtering or evaporation, but the disclosure is not limited thereto. The absorbing layer precursor contains copper, zinc, tin and sulfur, for fabricating the absorbing layer containing copper, zinc, tin and sulfur. In some other examples, the absorbing layer precursor contains copper, zinc, tin, sulfur and selenium, for fabricating the absorbing layer containing copper, zinc, tin, sulfur and selenium.

Then, a solid-phase vapor source is disposed in the chamber (Step S102). The solid-phase vapor source contains the elements corresponding to the absorbing layer precursor, such as tin. Thereby, the solid-phase vapor source is adapted for maintaining the proportion of tin in the absorbing layer formed from the absorbing layer precursor. In some other examples, the absorbing layer precursor contains copper, zinc, tin, sulfur and selenium, as well as the solid-phase vapor source further contains selenium. Thereby, the solid-phase vapor source is adapted for maintaining the proportion of selenium in the absorbing layer formed from the absorbing layer precursor. In this and examples, the order of Step S101 and Step S102 does not limit the disclosure.

Afterwards, the solid-phase vapor source is separated from the absorbing layer precursor by a predetermined distance (Step S103). The solid-phase vapor source faces and corresponds to the absorbing layer precursor. In this example, the predetermined distance is between 0.1 cm and 4 cm. In some other examples, the predetermined distance is between 0.1 cm and 2 cm.

Then, a heating process is performed so that the solid-phase vapor source vaporizes and transforms into a vapor, as well as an absorbing layer is formed on the substrate by the absorbing layer precursor (Step S104). In this example, the vapor contains tin, such as stannic sulfide, stannic selenide, stannous sulfide, stannous selenide or combinations thereof. In some other examples, the solid-phase vapor source contains sulfur and the vapor contains sulfur as well. In some other examples, the solid-phase vapor source contains selenium and the vapor contains selenium as well.

In this embodiment, the temperature during the heating process is between 200°C and 800°C, and the heating time is between 20 minutes and 3 hours. In some other examples, the temperature during the heating process is between 350°C and 650°C, and the heating time is between 30 minutes and 2 hours. The substrate is inert under the reaction temperature so that the substrate is not deteriorated and further affects the composition of the absorbing layer precursor.

Furthermore, during the heating process, the temperature in the chamber firstly reaches a vaporizing temperature. The solid-phase vapor source vaporizes and transforms into the vapor at the vaporizing temperature. Then, the temperature in the chamber is raised to a forming temperature. The absorbing layer precursor forms an absorbing layer on the substrate at the forming temperature. The forming temperature is higher than the vaporizing temperature.

During the heating process, the solid-phase vapor source vaporizes and transforms into a vapor containing tin so that a kinetic equilibrium of tin between the gas phase (the vapor) and the solid phase (the solid-phase vapor source) is achieved. Therefore, when the tin effuses from the absorbing layer precursor, the tin in the vapor compensates for the effusion. Thereby, the solid-phase vapor source is adapted for inhibiting the tin effusing from the absorbing layer precursor so as to maintain the proportion of tin in the formed absorbing layer. Since the proportion of tin in the formed absorbing layer is maintained, the absorbing remains to be single Kesterite form.

Please refer to FIGs. 1A, 2 and 3, FIG. 3 is a top view of the thermal treatment device in FIG. 1A before a solid-phase vapor source is disposed. The variations of the element composition in the absorbing layer before a solid vapor source is disposed are illustrated in the following comparisons.

According to the method described in FIG. 2, a substrate 20 is disposed in the chamber 11, and an absorbing layer precursor 30 is loaded on the substrate 20 (Step S101). The area of the absorbing layer precursor 30 is 8 cm multiplied by 8 cm (i.e., 8 cm x 8 cm), and the mole percentage of the element composition of the absorbing layer precursor 30 is shown in the following table.

| Element | Copper | Zinc | Tin | Sulfur | Copper/(Zinc+Tin) | Zinc/Tin |
|---|---|---|---|---|---|---|
| Percentage (%) | 22.13 | 15.22 | 13.41 | 49.24 | 0.77 | 1.14 |

Afterwards, tin sulfide powder is disposed on the two sides 200 of the substrate 20 for providing a supply source of tin. An absorbing layer is fabricated according to the above-mentioned Step S104. The reaction temperature is 500°C and the reaction time is 1 hour.

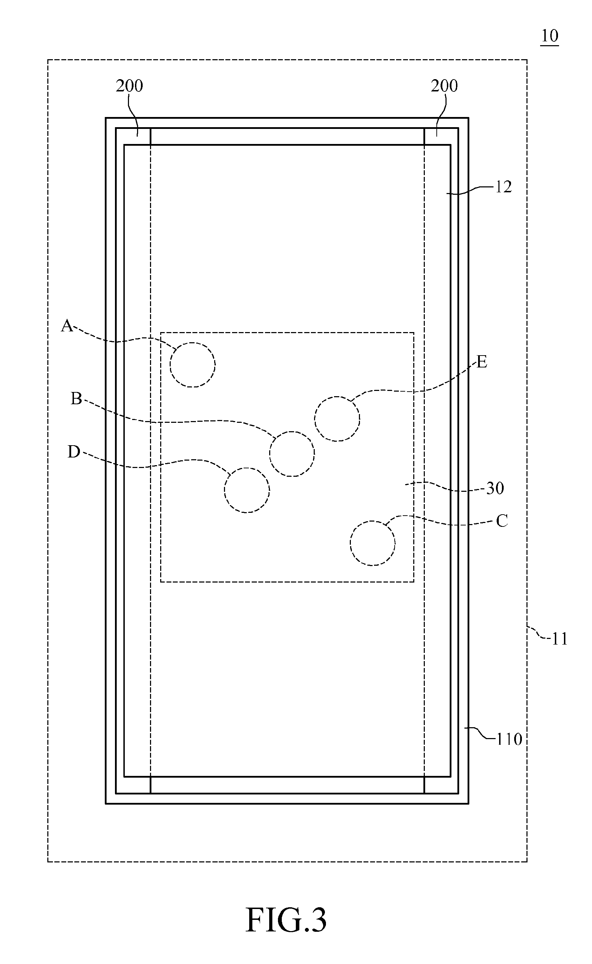

Finally, a test is performed on areas A to E in FIG. 3 for analyzing the element compositions in the areas A to E in the absorbing layer. The results of the test are shown in the following table.

| | Copper | Zinc | Tin | Sulfur | Copper/(Zinc+Tin) | Zinc/Tin |
|---|---|---|---|---|---|---|
| A | 21.35 | 15.62 | 13.70 | 49.33 | 0.73 | 1.14 |
| B | 27.11 | 17.06 | 11.33 | 44.50 | 0.95 | 1.51 |
| C | 22.01 | 15.31 | 13.72 | 48.96 | 0.76 | 1.12 |
| D | 26.11 | 17.11 | 13.61 | 43.17 | 0.85 | 1.26 |
| E | 24.79 | 16.82 | 13.05 | 45.34 | 0.83 | 1.29 |

The element compositions in the areas A to E are compared with the element compositions before the heating process. The ratio of zinc/tin in the area A is 1.14, the ratio of zinc/tin in the area B is 1.51, the ratio of zinc/tin in the area C is 1.12, the ratio of zinc/tin in the area D is 1.26, and the ratio of zinc/tin in the area E is 1.29. The ratios of zinc/tin in the areas A and C are in the range of 1.14 with 3% margin of error, that is, between 1.11 and 1.17.

When the ratio of zinc/tin is between 1.05 and 1.2, the formed absorbing layer is mainly a single Kesterite form. When the ratio of zinc/tin is beyond this range, other crystal forms are formed in the absorbing layer, and the performance of the solar cell is lowered. In the areas B, D and E, since the tin effuses from the absorbing layer precursor during the heating process, the proportion of tin in the formed absorbing layer is reduced. Thus, the ratio of zinc/tin is increased and other crystal forms (i.e. the Stannite form) are formed, which weakens the performance of the solar cell. In addition, since the ratio of zinc/tin in the areas A to E are apparently different from each other, the elements in the areas A to E is not uniformly distributed, and the transformation efficiency of the fabricated solar cell is worse.

Please refer to FIGs. 1A, 2 and 4, FIG. 4 is a top view of the thermal treatment device in FIG. 1A. The variations of the element composition in the absorbing layer after a solid vapor source is disposed are illustrated in the following examples.

According to the method described in FIG. 2, a substrate 20 is disposed in the chamber 11, and an absorbing layer precursor 30 is loaded on the substrate 20 (Step S101). The area of the absorbing layer precursor 30 is 8 cmx8 cm, and the mole percentage of the element composition of the absorbing layer precursor 30 is shown in the following table.

| Element | Copper | Zinc | Tin | Sulfur | Copper/(Zinc+Tin) | Zinc/Tin |
|---|---|---|---|---|---|---|
| Percentage (%) | 22.13 | 15.22 | 13.41 | 49.24 | 0.77 | 1.14 |

Then, the solid-phase vapor source 120 is disposed in the chamber 11 for serving as the source of tin (Step S102). In addition, argon and sulfur vapor are filled in the chamber 11. Then, the solid-phase vapor source 120 and the absorbing layer precursor 30 are kept by a predetermined distance (Step S103). Afterwards, an absorbing layer is fabricated according to Step S104. The distance between the solid-phase vapor source 120 and the absorbing layer precursor 30 is 0.5 cm, the reaction temperature is 500°C and the reaction time is 1 hour.

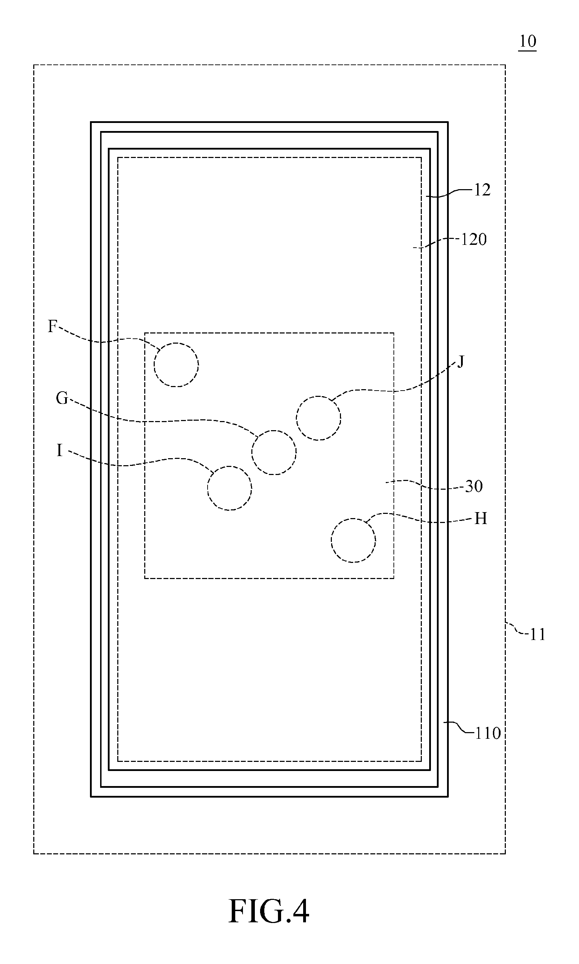

Finally, a test is performed on areas F to J in FIG. 4, for analyzing the element compositions in the areas F to J in the absorbing layer. The results of the test are shown in the following table.

| | Copper | Zinc | Tin | Sulfur | Copper/(Zinc+Tin) | Zinc/Tin |
|---|---|---|---|---|---|---|
| F | 21.85 | 14.98 | 12.81 | 50.36 | 0.78 | 1.17 |
| G | 21.56 | 15.06 | 13.11 | 50.27 | 0.77 | 1.15 |
| H | 22.13 | 14.73 | 13.35 | 49.79 | 0.79 | 1.10 |
| I | 23.01 | 16.06 | 14.29 | 46.64 | 0.76 | 1.12 |
| J | 21.08 | 15.11 | 13.26 | 50.55 | 0.74 | 1.14 |

The element compositions in the areas F to J are compared with the element compositions after the heating process is performed. The ratios of zinc/tin in the areas F to J are between 1.05 and 1.2, so that the proportion of tin in the absorbing layer is consistent, and other crystal forms are not generated in the absorbing layer. In addition, since the differences between the ratios of zinc/tin in the areas F to J are not apparent, the elements in the areas F to J is uniformly distributed, and the transformation efficiency of the fabricated solar cell is enhanced.

In these examples, the solid-phase vapor source 120 is adapted for inhibiting the effusion of tin from the absorbing layer precursor 30, so that the proportion of tin of the in the absorbing layer formed from the absorbing layer precursor 30 is maintained. Therefore, the ratio of zinc/tin ratio is consistent and is between 1.05 and 1.2, and the formed absorbing layer is mainly single Kesterite form. Also, the elements of the absorbing layer is uniform distributed, and the transformation efficiency of the solar cell is improved.

According to the above examples, the solid-phase vapor source is adapted for inhibiting tin effusing from the absorbing layer precursor and maintaining the proportion of tin in the absorbing layer formed from the absorbing layer precursor. Therefore, during the fabrication process of the absorbing layer of the solar cell, an absorbing layer having a single crystal form is formed, which solves the problem that different crystal forms are generated due to the effusion of the element in the absorbing layer. In addition, the elements in the absorbing layer, fabricated after the solid vapor source is disposed, is uniformly distributed, as well the transformation efficiency of the absorbing layer is improved.

In the above examples, the solid-phase vapor source and the absorbing layer precursor are constantly kept and maintained by a predetermined distance. In other words, the solid-phase vapor source is fixedly disposed in the chamber. However, the above description of "the solid-phase vapor source and the absorbing layer precursor are constantly kept and maintained by a predetermined distance" does not limit the disclosure. In some other examples, the distance between the solid-phase vapor source and the absorbing layer precursor is adjusted according to the temperature in the chamber.

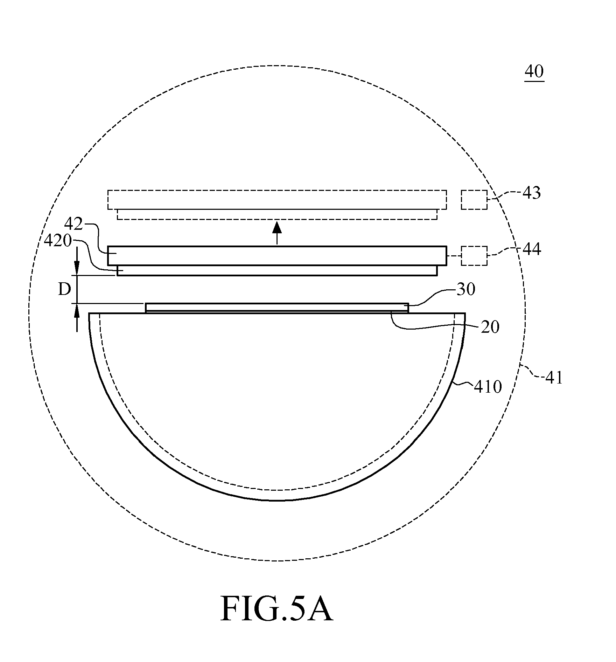

Please refer to FIG 5A, which is a schematic side view of a thermal treatment device according to another example of the disclosure. The example is similar with the embodiment of FIG. 1A, and the differences are that the thermal treatment device 40 of the example is capable of adjusting the distance between the solid-phase vapor source and the absorbing layer precursor according to the temperature in the chamber.

The thermal treatment device 40 is used for performing a thermal treatment on an absorbing layer precursor 30 on a substrate 20 of a solar cell. The substrate 20 and the absorbing layer precursor 30 are similar with those described in FIG. 1A, so the repeated substrate 20 and the absorbing layer precursor 30 are not described again. In the following descriptions, the absorbing layer precursors containing copper, zinc, tin and sulfur are described.

The thermal treatment device 40 comprises a first chamber 41, a carrier 42, a temperature controller 43 and a controller 44. The first chamber 41 has a base 410. The substrate 20 is disposed on the base 410. The first chamber 41 is a tubular heating furnace, but the disclosure is not limited thereto. The first chamber 41 has a non-oxygen environment so as to prevent the composition of the absorbing layer precursor 30 from being oxidized by oxygen. Also, the pressure in the first chamber 41 is negative pressure or equal to the external pressure.

The carrier 42 is disposed in the first chamber 41. The carrier 42 faces both the substrate 20 and the absorbing layer precursor 30. A solid-phase vapor source 420 is disposed on the carrier 42. The carrier 42 is capable of selectively moving with the solid-phase vapor source 420 so as to control the distance between the solid-phase vapor source 420 on the carrier 42 and the absorbing layer precursor 30. For example, the carrier 42 is capable of maintaining a predetermined distance D between the solid-phase vapor source 420 and the absorbing layer precursor 30 or moving with the solid-phase vapor source 420 away from the absorbing layer precursor 30 so that the distance between the solid-phase vapor source 420 and the absorbing layer precursor 30 is longer than the predetermined distance D. In this examples, the predetermined distance D is between 0.1 cm and 4 cm. In some other examples, the predetermined distance D is between 0.1 cm and 2 cm.

In this example, the solid-phase vapor source 420 contains tin. Therefore, during the thermal treatment, the solid-phase vapor source 420 vaporizes and transforms to a vapor containing tin as well as the proportion of tin in the absorbing layer formed from the absorbing layer precursor 30 is maintained. For example, the solid-phase vapor source 420 is stannic sulfide, stannous sulfide, stannic selenide, stannous selenide or combinations thereof, but the disclosure is not limited thereto. In some other examples, the solid-phase vapor source 420 further contains sulfur, so that the vapor formed from the solid-phase vapor source 420 further contains sulfur. Therefore, the solid-phase vapor source 420 is adapted for inhibiting or even preventing the sulfur from effusing from the absorbing layer precursor 30. Furthermore, the proportion of sulfur in the absorbing layer formed from the absorbing layer precursor 30 is maintained. Similarly, in the examples that the absorbing layer precursor 30 contains copper, zinc, tin, sulfur and selenium, the solid-phase vapor source 420 further contains selenium so that the vapor formed from the solid-phase vapor source 420 further contains selenium. Therefore, the solid-phase vapor source 420 is adapted for inhibiting or even preventing the selenium from effusing from the absorbing layer precursor 30 Furthermore, the proportion of selenium in the absorbing layer formed from the absorbing layer precursor 30 is maintained.

The temperature controller 43 is assembled in the first chamber 41. The temperature controller 43 is adapted for adjusting the temperature in the first chamber 41, i.e. raising, lowering or maintaining the temperature in the first chamber 41. The controller 44 is adapted for controlling the carrier 42 so that the carrier 42 moves with the solid-phase vapor source 420 according to the temperature in the first chamber 41. The followings describe how the carrier 42 moves with the solid-phase vapor source 420 according to the temperature in the first chamber 41.

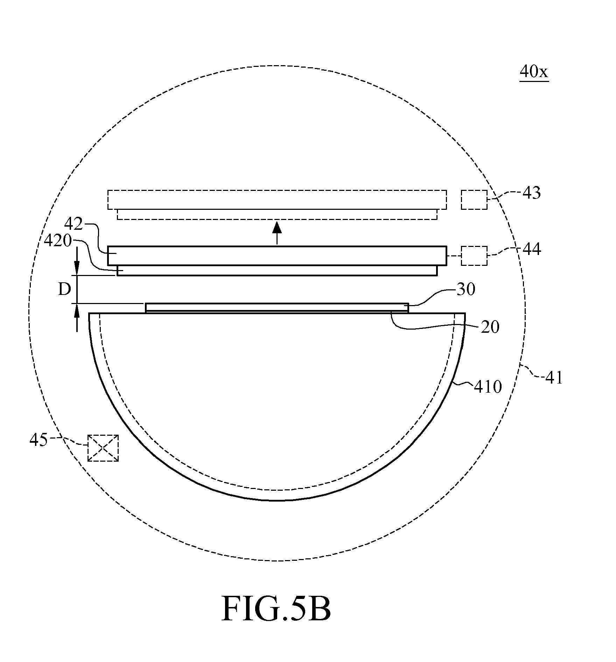

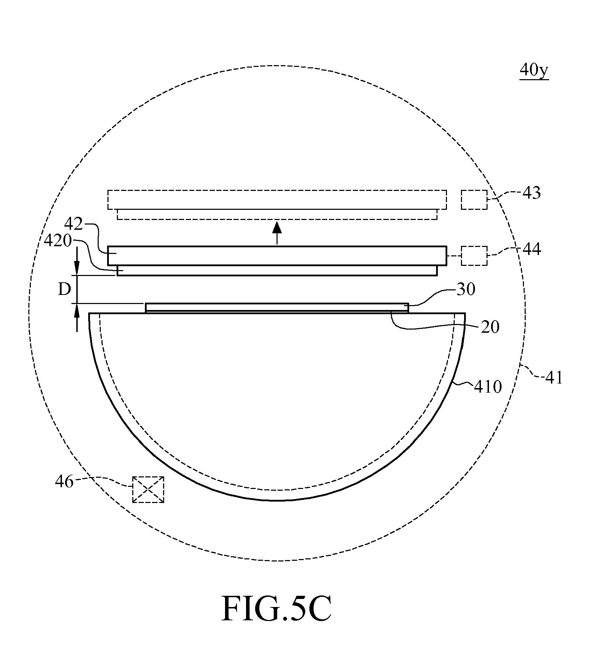

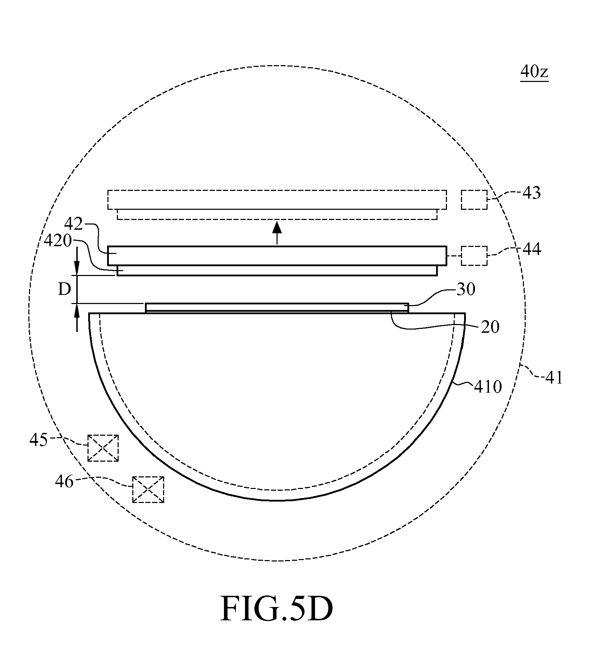

Please refer to FIGs. 5B-5D. FIGs. 5B-5D are schematic side views of a thermal treatment device. The examples in FIGs. 5B-5D are similar with the example in FIG. 5A. The differences are that the thermal treatment device 40x in FIG. 5B further comprises a first gas supply 45, the thermal treatment device 40y in FIG. 5C further comprises a second gas supply 46, as well as the thermal treatment device 40z in FIG. 5D further comprises a first gas supply 45 and a second gas supply 46. The first gas supply 45 and the second gas supply 46 are similar with the first gas supply and the second gas supply described in FIGs. 1D-1F, so the repeated is not described again.

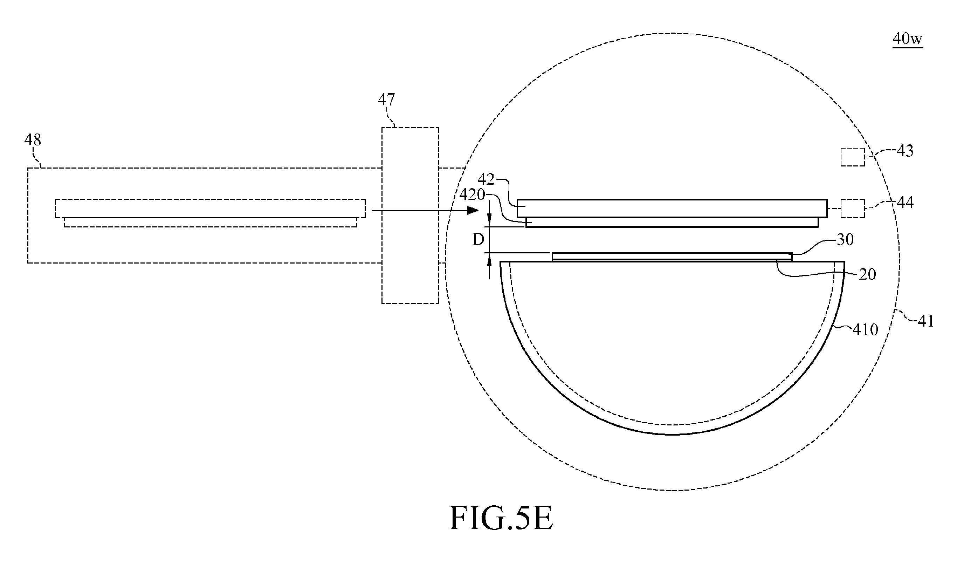

Please refer to FIG. 5E, FIG. 5E is a schematic side view of a thermal treatment device. The example in FIG. 5E is similar with the example in FIG. 5B. The differences are that the thermal treatment device 40w in FIG. 5E further comprises a load-locking unit 47 and a second chamber 48.

The load-locking unit 47 is connected with the first chamber 41 and the second chamber 48. The load-locking unit 47, the first chamber 41 and the second chamber 48 are airtight therebetween. The controller 44 is adapted for controlling the load-locking unit 47 so that the load-locking unit 47 separates the first chamber 41 from the second chamber 48 or the load-locking unit 47 connects the first chamber 41 and the second chamber 48. In other words, the controller 44 is adapted for controlling the carrier 42 so that the carrier 42 moves with the solid-phase vapor source 420 according to the temperature in the first chamber 41; the controller 44 is also adapted for controlling the carrier 42 so that the carrier 42 moves with the solid-phase vapor source 420 from the first chamber 41 through the load-locking unit 47 to the second chamber 48 or the carrier 42 moves with the solid-phase vapor source 420 from the second chamber 48 through the load-locking unit 47 to the first chamber 41 according to the temperature in the first chamber 41.

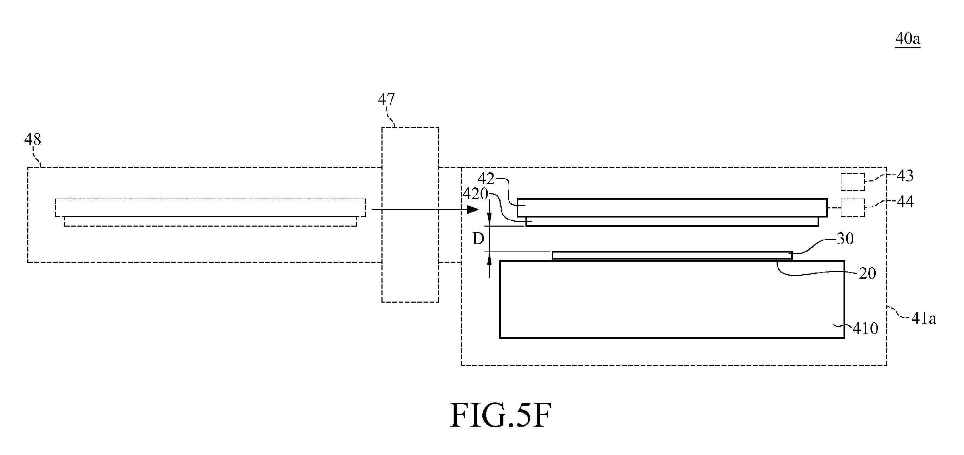

Please refer to FIG. 5F, which is a schematic side view of a thermal treatment device. The example in FIG. 5F is similar with the examples in FIGs. 5A-5E. The differences are that the first chambers in FIGs. 5A-5E are tubular heating furnaces, and the first chamber 41a in the thermal treatment device 40a in FIG. 5F is a rapid thermal process (RTP, or a rapid thermal annealing, RTA). In other words, users can choose an appropriate first chamber according to their needs.

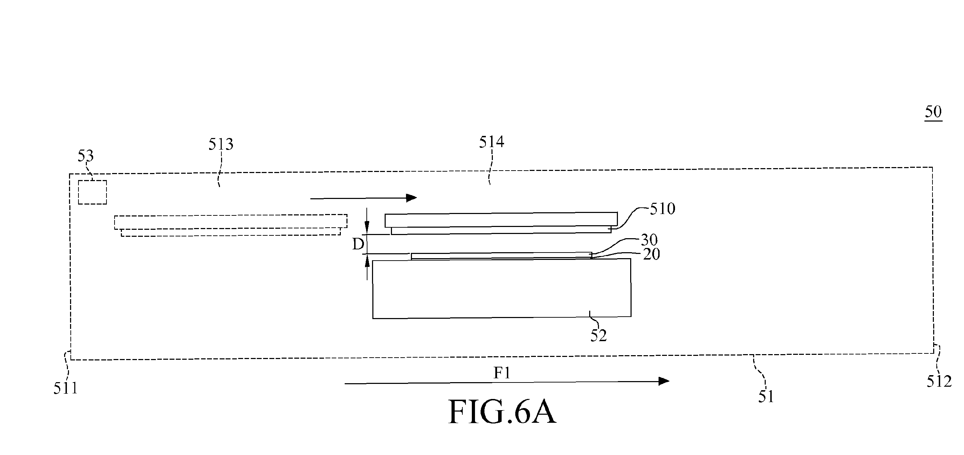

Please refer to FIG. 6A, which is a schematic side view of a thermal treatment device. The differences between the examples in FIG. 5A-5F and the examples in FIG. 6A are that the thermal treatment devices in FIG. 5A-5F comprise a first chamber and a second chamber while the thermal treatment device in FIG. 6A only comprises a single chamber.

The thermal treatment device 50 is used for performing a thermal treatment on an absorbing layer precursor 30 disposed on a substrate 20 of a solar cell. The substrate 20 and the absorbing layer precursor 30 are similar with those described in FIG. 1A, so the repeated substrate 20 and the absorbing layer precursor 30 are not described again. In the following descriptions, the absorbing layer precursors containing copper, zinc, tin and sulfur are described.

The thermal treatment device 50 comprises a chamber 51, a mobile carrier 52 and a temperature controller 53. The chamber 51 of the example is, but not limited to, a tunnel furnace. Further, the chamber 51 has a first side 511 and a second side 512 that are opposite to each other. The temperature of the chamber 51 varies from the first side 511 to the second side 512. Accordingly, the chamber 51 has a heating zone 513 and a thermal treatment zone 514 in sequence. The heating zone 513 has a vaporizing temperature, the thermal treatment zone 514 has a forming temperature, and the vaporizing temperature is lower than the forming temperature. A solid-phase vapor source 510 is disposed in the thermal treatment zone 514 of the chamber 51. The solid-phase vapor source 510 contains tin for maintaining the proportion of tin in the absorbing layer formed from the absorbing layer precursor 30. For example, the solid-phase vapor source 510 is stannic sulfide, stannous sulfide, stannic selenide, stannous selenide or combinations thereof, but the disclosure is not limited thereto. In other examples, the solid-phase vapor source 510 may comprise sulfur or/and selenium.

The mobile carrier 52 is movably disposed in the chamber 51, and the substrate 20 is disposed on the mobile carrier 52. The mobile carrier 52 is adapted for moving from the heating zone 513 to the thermal treatment zone 514 along a first direction F1 (thus, from the first side 511 to the second side 512). When the mobile carrier 52 is in the thermal treatment zone 514, the mobile carrier 52 and the solid-phase vapor source 30 are kept by a predetermined distance D. When the mobile carrier 52 moves out of the thermal treatment zone 514, the distance between the absorbing layer precursor 30 on the substrate 20 and the solid-phase vapor source 510 is longer than the predetermined distance D. In this example the predetermined distance D is between 0.1 cm and 4 cm. In some other examples, the predetermined distance D is between 0.1 cm and 2 cm.

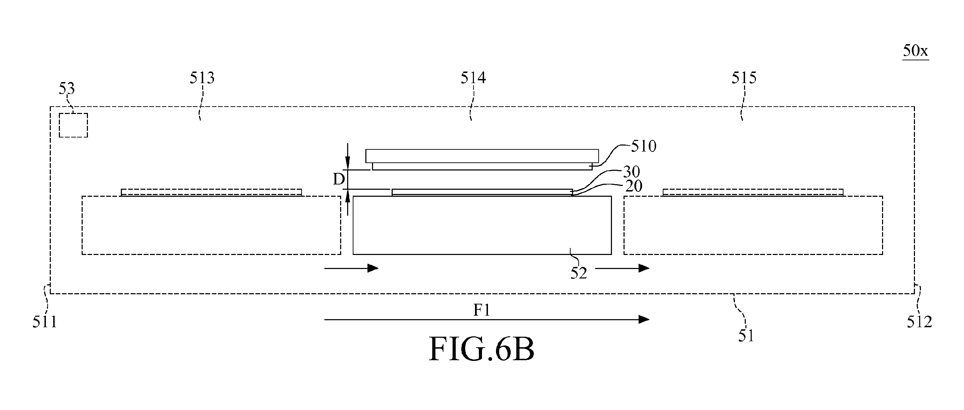

Please refer to FIG. 6B, which is a schematic side view of a thermal treatment device. In this example, the chamber 51 further comprises a cooling zone 515. The thermal treatment zone 514 is disposed between the heating zone 513 and the cooling zone 515. The cooling zone 515 has an effusing temperature, and the effusing temperature is lower than the forming temperature. In this example, the effusing temperature is between 350°C and 650°C.

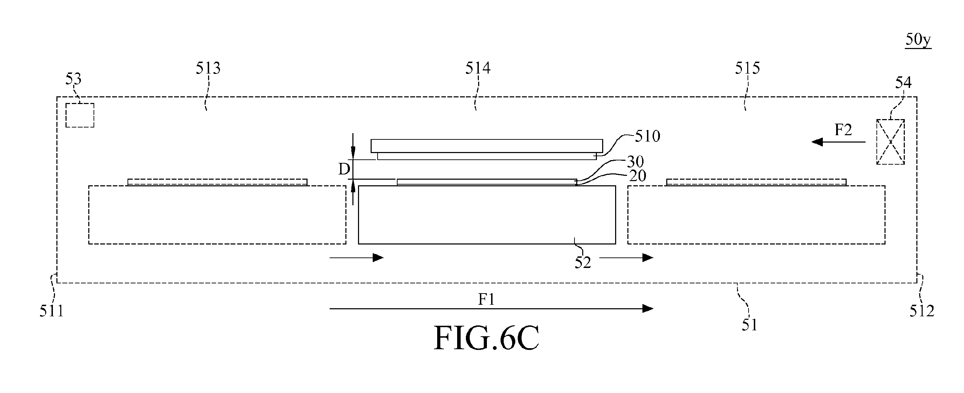

Please refer to FIG. 6C, which is a schematic side view of a thermal treatment device. In this invention, the thermal treatment device 50y further comprises a gas intake unit 54. The gas intake unit 54 is adapted for bringing a gas in the chamber 51, so that the gas moves in the chamber 51 along a second direction F2. The second direction F2 is reverse to the first direction F1. Thereby, when the mobile carrier 52 moves with the substrate 20 from the thermal treatment zone 514 to the cooling zone 515, the gas brings the vapor generated from the solid-phase vapor source 510 to the heating zone 513 along the second direction F2, so as to prevent the vapor transformed from the solid-phase vapor source 510 from moving with the mobile carrier 52 and entering the cooling zone 515.

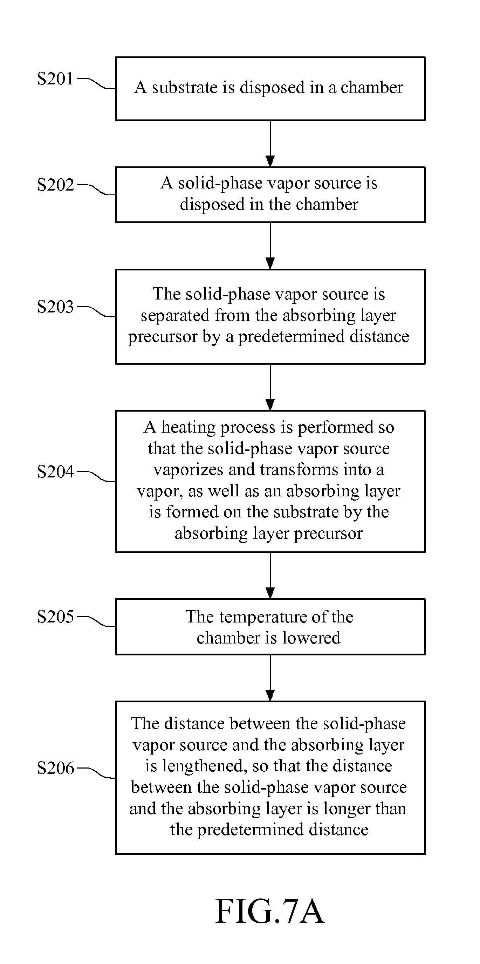

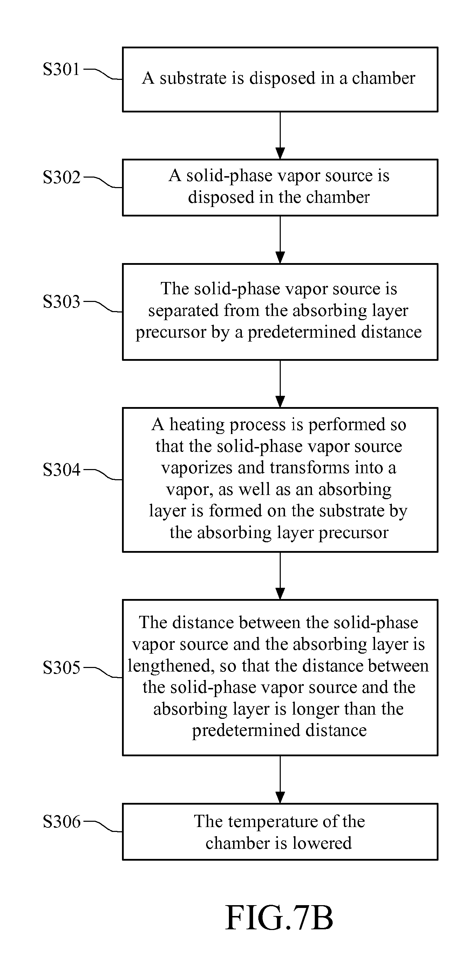

The followings describe how the carrier moving with the solid-phase vapor source according to the temperature in the chamber (or the first chamber) for the fabrication of the absorbing layer of the solar cell. Please refer to FIGs. 7A and 7B, which are flow charts of a method for fabricating an absorbing layer of a solar cell. The thermal treatment devices described in the examples are shown in FIGs. 5A-5F and 6A-6C. In this example, Step S201 to Step S204 are identical or similar with Step S101 to Step S104 in FIG. 2.

In this example, the solid-phase vapor source and the absorbing layer precursor are separated by a predetermined distance when the temperature in the chamber (or the first chamber) is equal to or lower than the forming temperature (Step S203). In other words, the solid-phase vapor source and the absorbing layer precursor should be separated by the predetermined distance before the absorbing layer precursor forms the absorbing layer (forming temperature). In some other examples, Step S203 is performed when the temperature in the chamber (or the first chamber) is equal to or higher than an effusing temperature. The effusing temperature represents the temperature that tin effuses from the absorbing layer

After Step S204, the temperature of the chamber (or the first chamber) is lowered (Step S205).

Then, the distance between the solid-phase vapor source and the absorbing layer is lengthened, so that the distance between the solid-phase vapor source and the absorbing layer is longer than the predetermined distance (Step S206). In the examples of FIGs. 5A-5D, the distance between the solid-phase vapor source and the absorbing layer is lengthened. In the examples of FIGs. 5E-5F, the solid-phase vapor source moves from the first chamber to the second chamber. In the examples of FIGs. 6A-6C, the absorbing layer moves from the thermal treatment zone to the cooling zone.

In this example, the order of Step S205 and Step S206 does not limit the disclosure. In some other examples, the distance between the solid-phase vapor source and the absorbing layer in the chamber (or the first chamber) is lengthened to be greater than the predetermined distance. Then, the temperature in the chamber (or the first chamber) is lowered (FIG. 7B). In some other examples, the distance between the solid-phase vapor source and the absorbing layer in the chamber (or the first chamber) is lengthened to be greater than the predetermined when the temperature in the chamber (or the first chamber) is lowered.

In this and some other examples, the step of "the distance between the solid-phase vapor source and the absorbing layer in the chamber (or the first chamber) is lengthened, so that the distance between the solid-phase vapor source and the absorbing layer is longer than the predetermined distance" (Step S206 or Step S305) corresponds to the effusing temperature (the temperature that tin effuses from the absorbing layer). Moreover, the solid-phase vapor source vaporizes and transforms into the vapor containing tin at the vaporizing temperature, and the effusing temperature is higher than the vaporizing temperature. Therefore, when the temperature is between the vaporizing temperature and the effusing temperature, tin does not effuse from the absorbing layer. However, the solid-phase vapor source keeps vaporizing and transforming into the vapor because the temperature in the chamber (or the first chamber) is higher than the vaporizing temperature. Thus, when the chamber (or the first chamber) cools down and the temperature in the chamber (or the first chamber) is lower than the vaporizing temperature, the vapor solidifies and transforms into a solid, deposited on the surface of the absorbing layer. In order to solve the above problem, the distance between the solid-phase vapor source and the absorbing layer should be longer than the predetermined distance before the temperature in the chamber (or the first chamber) is equal to the effusing temperature (during the cooling process). In some examples, the distance between the solid-phase vapor source and the absorbing layer is lengthened when the temperature in the chamber (or the first chamber) is lower than or equal to the forming temperature.

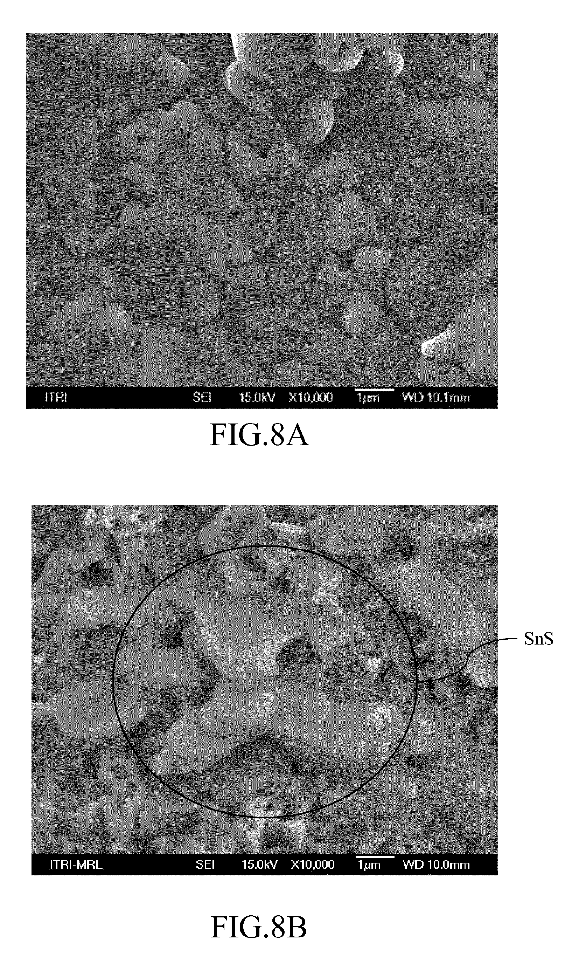

Please refer to FIGs. 8A-8B, FIG. 8A is a view of a result of scanning electron microscopic analysis of an absorbing layer fabricated according to the method of FIG. 7A. FIG. 8B is a view of a result of scanning electron microscopic analysis of stannic sulfide deposited on an absorbing layer.

According to the above examples, the distance between the solid-phase vapor source and the absorbing layer is lengthened to be greater than the predetermined distance (such as lengthening the distance between the solid-phase vapor source and the absorbing layer, moving the solid-phase vapor source from the first chamber to the second chamber or moving the absorbing layer to the cooling zone) when the temperature in the chamber (or the first chamber) is higher than or equal to the effusing temperature (the temperature that tin effuses from the absorbing layer). Thus, the vapor generated from the solid-phase vapor source solidifying and depositing on the surface of the absorbing layer during the cooling process can be avoided. Therefore, the fabricated solar cell has a better photoelectric effect because stannic sulfide does not deposit on the surface of the absorbing layer.

In FIG. 8B, stannic sulfide is deposited on the surface of an absorbing layer. Therefore, when fabricating a solar cell from the absorbing layer in FIG. 8B, the solar cell has a low photoelectric effect or even lack of the photoelectric effect. The absorbing layer, which is fabricated according to the method for fabricating an absorbing layer of a solar cell, is shown in FIG. 8A. As shown in the figure, stannic sulfide is not deposited on the surface of the absorbing layer, so that the solar cell fabricated from the absorbing layer has a better photoelectric effect.

It will be apparent to those skilled in the art that various modifications and variations can be made to the disclosed examples. It is intended that the specification and examples be considered as exemplary only, with a true scope of the disclosure being indicated by the following claims.

## Claims

1. A method for fabricating an absorbing layer of a solar cell, **characterized by**:
maintaining a predetermined distance (D) between a solid-phase vapor source (120, 510) in a chamber (11, 51) and an absorbing layer precursor (30) on a substrate (20) in the chamber (11, 51) (S103), wherein the solid-phase vapor source (120, 510) contains tin and the absorbing layer precursor (30) contains copper, zinc, tin and sulfur;
raising the temperature inside the chamber (11, 510) to a forming temperature, so that the absorbing layer precursor (30) forms an absorbing layer on the substrate (20) (S104); lowering the temperature in the chamber (11, 51) (S205); and
when the temperature in the chamber (11, 51) is higher than or equal to an effusing temperature of tin effusing from the absorbing layer, moving the solid-phase vapor source (120, 510) away from the absorbing layer so that the distance between the solid-phase vapor source (120, 510) and the absorbing layer is longer than the predetermined distance (D) (S206).

2. The method for fabricating the absorbing layer of the solar cell according to claim 1, before the step of raising the temperature in the chamber (11, 51) to the forming temperature (S104), further comprising raising the temperature in the chamber (11, 51) to a vaporizing temperature, so that the solid-phase vapor source (120, 510) vaporizes and transforms to a vapor, the vapor contains tin, and the forming temperature is higher than the vaporizing temperature.

3. The method for fabricating the absorbing layer of the solar cell according to claim 1, before the step of maintaining the predetermined distance (D) (S103), wherein the temperature in the chamber (11, 51) is equal to or lower than the forming temperature.

4. The method for fabricating the absorbing layer of the solar cell according to claim 1, after the step of forming the absorbing layer (S204), further comprising moving the solid-phase vapor source (120, 510) away from the absorbing layer so that the distance between the solid-phase vapor source (120, 510) and the absorbing layer is longer than the predetermined distance (D) (S206).

5. The method for fabricating the absorbing layer of the solar cell according to claim 1, wherein the effusing temperature is higher than the vaporizing temperature.

6. The method for fabricating the absorbing layer of the solar cell according to claim 1, wherein the effusing temperature is between 350°C and 650°C.

7. The method for fabricating the absorbing layer of the solar cell according to claim 1, wherein the predetermined distance (D) is between 0.1 cm and 4 cm.

8. The method for fabricating the absorbing layer of the solar cell according to claim 1, wherein the solid-phase vapor source (120, 510) is a planar solid-phase vapor source or an array of dot-shaped solid-phase vapor source.

9. The method for fabricating the absorbing layer of the solar cell according to claim 1, wherein the absorbing layer precursor (30) further contains selenium, and the solid-phase vapor source (120, 510) and the vapor further contain selenium.

10. The method for fabricating the absorbing layer of the solar cell according to claim 1, wherein the solid-phase vapor source (120, 510) and the vapor further contain sulfur.

11. The method for fabricating the absorbing layer of the solar cell according to claim 1, wherein the solid-phase vapor source (120, 510) is stannic sulfide, stannous sulfide, stannic selenide, stannous selenide or combinations thereof.

12. The method for fabricating the absorbing layer of the solar cell according to claim 1, further comprising filling a first gas in the chamber (11, 51), wherein the first gas is sulfur vapor, selenium vapor, hydrogen sulfide, hydrogen selenide or combinations thereof.

13. The method for fabricating the absorbing layer of the solar cell according to claim 1, further comprising filling a second gas in the chamber (11, 51), wherein the second gas is stannic sulfide, stannous sulfide, stannic selenide, stannous selenide or combinations thereof.

14. The method for fabricating the absorbing layer of the solar cell according to claim 1, wherein the vaporizing temperature and the forming temperature are between 200°C and 800°C.

15. A thermal treatment device (50), used for performing a thermal treatment on an absorbing layer precursor (30) on a substrate (20) of a solar cell, the absorbing layer precursor (30) containing copper, zinc, tin and sulfur, the thermal treatment device (50) **characterized by**:
a single chamber (51) having a heating zone (513), a thermal treatment zone (514) and a cooling zone (515) in sequence, the temperature in the heating zone (513) is set to be lower than the temperature in the thermal treatment zone (514), wherein a solid-phase vapor source (510) is disposed in the thermal treatment zone (514), and the solid-phase vapor source (510) contains tin, and the temperature in the cooling zone (515) is set to be lower than the temperature in the thermal treatment zone (514);
a mobile carrier (52) movably disposed in the chamber (51), wherein the mobile carrier (52) is adapted for moving from the heating zone (513) to the thermal treatment zone (514) along a first direction, and the substrate (20) is disposed on the mobile carrier (52);
a gas intake unit (54), wherein the gas intake unit (54) is adapted for bringing a gas in the single chamber (51), so that the gas moves in the chamber (51) along a second direction, and the second direction is reverse to the first direction; and
a temperature controller (53), assembled at the chamber (51), wherein the temperature controller (53) is adapted for adjusting the temperature in the single chamber (51);
wherein, when the mobile carrier (52) moves to the thermal treatment zone (514), the absorbing layer precursor (30) on the substrate (20) and the solid-phase vapor source (510) are kept by a predetermined distance (D).

16. The thermal treatment device (50) according to claim 15, wherein the absorbing layer precursor (30) further contains selenium, and the solid-phase vapor source (510) further contains selenium.

17. The thermal treatment device (50) according to claim 15, wherein the solid-phase vapor source (510) further contains sulfur.

18. The thermal treatment device (50) according to claim 15, wherein the predetermined distance (D) is between 0.1 cm and 4 cm.

19. The thermal treatment device (50) according to claim 15, wherein the solid-phase vapor source (510) is a planar solid-phase vapor source or an array of dot-shaped solid-phase vapor source.

20. The thermal treatment device (50) according to claim 15, wherein the solid-phase vapor source (510) is stannic sulfide, stannous sulfide, stannic selenide, stannous selenide or combinations thereof.

## Patentansprüche

1. Verfahren zum Herstellen einer Absorptionsschicht einer Solarzelle, **gekennzeichnet durch**:
Aufrechterhalten eines vorbestimmten Abstands (D) zwischen einer Festphasen-Dampfquelle (120, 510) in einer Kammer (11, 51) und eines Absorptionsschicht-Ausgangsstoffs (30) an einem Substrat (20) in der Kammer (11, 51) (S103), wobei die Festphasen-Dampfquelle (120, 510) Zinn enthält und der Absorptionsschicht-Ausgangsstoff (30) Kupfer, Zink, Zinn und Schwefel enthält;
Erhöhen der Temperatur in der Kammer (11, 510) auf eine Umformtemperatur, sodass der Absorptionsschicht-Ausgangsstoff (30) eine Absorptionsschicht an dem Substrat (20) bildet (S104); Absenken der Temperatur in der Kammer (11, 51) (S205); und wenn die Temperatur in der Kammer (11, 51) höher als oder gleich einer Ausströmtemperatur von Zinn ist, das von der Absorptionsschicht ausströmt, wird die Festphasen-Dampfquelle (120, 510) von der Absorptionsschicht weg bewegt, sodass der Abstand zwischen der Festphasen-Dampfquelle (120, 510) und der Absorptionsschicht größer ist als der vorbestimmte Abstand (D) (S206).

2. Verfahren zum Herstellen der Absorptionsschicht der Solarzelle gemäß Anspruch 1, vor dem Schritt des Erhöhens der Temperatur in der Kammer (11, 51) auf eine Umformtemperatur (S104), ferner aufweisend Erhöhen der Temperatur in der Kammer (11, 51) auf eine Verdampftemperatur, sodass die Festphasen-Dampfquelle (120, 510) verdampft und sich in einen Dampf umwandelt, wobei der Dampf Zinn enthält, und die Umformtemperatur höher ist als die Verdampftemperatur.

3. Verfahren zum Herstellen der Absorptionsschicht der Solarzelle gemäß Anspruch 1, vor dem Schritt des Aufrechterhaltens des vorbestimmten Abstands (D) (S103), wobei die Temperatur in der Kammer (11, 51) gleich oder geringer ist als die Umformtemperatur.

4. Verfahren zum Herstellen der Absorptionsschicht der Solarzelle gemäß Anspruch 1, nach dem Schritt des Formens der Absorptionsschicht (S204), ferner aufweisend Bewegen der Festphasen-Dampfquelle (120, 510) weg von der Absorptionsschicht, sodass der Abstand zwischen der Festphasen-Dampfquelle (120, 510) und der Absorptionsschicht größer ist als der vorbestimmte Abstand (D) (S206).

5. Verfahren zum Herstellen der Absorptionsschicht der Solarzelle gemäß Anspruch 1, wobei die Ausströmtemperatur höher ist als die Verdampftemperatur.

6. Verfahren zum Herstellen der Absorptionsschicht der Solarzelle gemäß Anspruch 1, wobei die Ausströmtemperatur zwischen 350°C und 650°C ist.

7. Verfahren zum Herstellen der Absorptionsschicht der Solarzelle gemäß Anspruch 1, wobei der vorbestimmte Abstand (D) zwischen 0,1 cm und 4 cm ist.

8. Verfahren zum Herstellen der Absorptionsschicht der Solarzelle gemäß Anspruch 1, wobei die Festphasen-Dampfquelle (120, 510) eine ebene Festphasen-Dampfquelle oder eine Anordnung einer punktförmigen Festphasen-Dampfquelle ist.

9. Verfahren zum Herstellen der Absorptionsschicht der Solarzelle gemäß Anspruch 1, wobei der Absorptionsschicht-Ausgangsstoff (30) ferner Selen enthält, und die Festphasen-Dampfquelle (120, 510) und der Dampf ferner Selen enthalten.

10. Verfahren zum Herstellen der Absorptionsschicht der Solarzelle gemäß Anspruch 1, wobei die Festphasen-Dampfquelle (120, 510) und der Dampf ferner Schwefel enthalten.

11. Verfahren zum Herstellen der Absorptionsschicht der Solarzelle gemäß Anspruch 1, wobei die Festphasen-Dampfquelle (120, 510) Zinn(IV)-sulfid, Zinn(II)-sulfid, Zinn(IV)-selenid, Zinn(II)-selenid oder Verbindungen davon ist.

12. Verfahren zum Herstellen der Absorptionsschicht der Solarzelle gemäß Anspruch 1, ferner aufweisend Füllen eines ersten Gases in die Kammer (11, 51), wobei das erste Gas Schwefeldampf, Selendampf, Schwefelwasserstoff, Selenwasserstoff oder Verbindungen davon ist.

13. Verfahren zum Herstellen der Absorptionsschicht der Solarzelle gemäß Anspruch 1, ferner aufweisend Füllen eines zweiten Gases in die Kammer (11, 51), wobei das zweite Gas Zinn(IV)-sulfid, Zinn(II)-sulfid, Zinn(IV)-selenid, Zinn(II)-selenid oder Verbindungen davon ist.

14. Verfahren zum Herstellen der Absorptionsschicht der Solarzelle gemäß Anspruch 1, wobei die Verdampftemperatur und die Umformtemperatur zwischen 200°C und 800°C ist.

15. Wärmebehandlungsvorrichtung (50), die zum Durchführen einer Wärmebehandlung an einem Absorptionsschicht-Ausgangsstoff (30) an einem Substrat (20) einer Solarzelle verwendet wird, wobei der Absorptionsschicht-Ausgangsstoff (30) Kupfer, Zink, Zinn und Schwefel enthält, wobei die Wärmebehandlungsvorrichtung (50) **gekennzeichnet ist durch**:
eine einzelne Kammer (51) mit einer Heizzone (513), einer Wärmebehandlungszone (514) und einer Kühlzone (515) in Reihe, wobei die Temperatur in der Heizzone (513) als niedriger festgelegt ist als die Temperatur in der Wärmebehandlungszone (514), wobei eine Festphasen-Dampfquelle (510) in der Wärmebehandlungszone (514) angeordnet ist, und die Festphasen-Dampfquelle (510) Zinn enthält, und die Temperatur in der Kühlzone (515) als niedriger festgelegt ist als die Temperatur in der Wärmebehandlungszone (514);
einen bewegbar in der Kammer (51) angeordneten mobilen Träger (52), wobei der mobile Träger (52) angepasst ist zum Bewegen von der Heizzone (513) zu der Wärmebehandlungszone (514) entlang einer ersten Richtung, und das Substrat (20) am mobilen Träger (52) angeordnet ist;
eine Gaseintrittseinheit (54), wobei die Gaseintrittseinheit (54) angepasst ist zum Einbringen eines Gases in die einzelne Kammer (51), sodass sich das Gas in der Kammer (51) entlang einer zweiten Richtung bewegt und die zweite Richtung entgegengesetzt zu der ersten Richtung ist; und
eine an der Kammer (51) montierte Temperatursteuereinrichtung (53), wobei die Temperatursteuereinrichtung (53) angepasst ist zum Einstellen der Temperatur in der einzelnen Kammer (51);
wobei, wenn der mobile Träger (52) sich zu der Wärmebehandlungszone (514) bewegt, der Absorptionsschicht-Ausgangsstoff (30) an dem Substrat (20) und die Festphasen-Dampfquelle (510) mit einem vorbestimmten Abstand (D) gehalten werden.

16. Wärmebehandlungsvorrichtung (50) gemäß Anspruch 15, wobei der Absorptionsschicht-Ausgangsstoff (30) ferner Selen enthält, und die Festphasen-Dampfquelle (510) ferner Selen enthält.

17. Wärmebehandlungsvorrichtung (50) gemäß Anspruch 15, wobei die Festphasen-Dampfquelle (510) ferner Schwefel enthält.

18. Wärmebehandlungsvorrichtung (50) gemäß Anspruch 15, wobei der vorbestimmte Abstand (D) zwischen 0,1 cm und 4 cm ist.

19. Wärmebehandlungsvorrichtung (50) gemäß Anspruch 15, wobei die Festphasen-Dampfquelle (510) eine ebene Festphasen-Dampfquelle oder eine Anordnung einer punktförmigen Festphasen-Dampfquelle ist.

20. Wärmebehandlungsvorrichtung (50) gemäß Anspruch 15, wobei die Festphasen-Dampfquelle (510) Zinn(IV)-sulfid, Zinn(II)-sulfid, Zinn(IV)-selenid, Zinn(II)-selenid oder Verbindungen davon ist.

## Revendications

1. Procédé de fabrication d'une couche d'absorption d'une cellule solaire, **caractérisé par** :
le maintien d'une distance prédéterminée (D) entre une source de vapeur en phase solide (120, 510) dans une chambre (11, 51) et un précurseur de couche d'absorption (30) sur un substrat (20) dans la chambre (11, 51) (S103), dans lequel la source de vapeur en phase solide (120, 510) contient de l'étain et le précurseur de couche d'absorption (30) contient du cuivre, du zinc, de l'étain et du soufre ;
l'augmentation de la température à l'intérieur de la chambre (11, 510) à une température de formage, de sorte que le précurseur de couche d'absorption (30) forme une couche d'absorption sur le substrat (20) (S104) ; la diminution de la température dans la chambre (11, 51) (S205) ; et lorsque la température dans la chambre (11, 51) est supérieure ou égale à une température d'efffusion de l'étain effusant depuis la couche d'absorption, l'éloignement de la source de vapeur en phase solide (120, 510) depuis la couche d'absorption de sorte que la distance entre la source de vapeur en phase solide (120, 510) et la couche d'absorption soit plus longue que la distance prédéterminée (D) (S206).

2. Procédé de fabrication de la couche d'absorption de la cellule solaire selon la revendication 1, avant l'étape d'élévation de la température dans la chambre (11, 51) à la température de formage (S104), comprenant en outre l'élévation de la température dans la chambre (11, 51) à une température de vaporisation, de sorte que la source de vapeur en phase solide (120, 510) se vaporise et se transforme en une vapeur, la vapeur contient de l'étain, et la température de formage est supérieure à la température de vaporisation.

3. Procédé de fabrication de la couche d'absorption de la cellule solaire selon la revendication 1, avant l'étape de maintien de la distance prédéterminée (D) (S103), dans lequel la température dans la chambre (11, 51) est égale ou inférieure à la température de formage.

4. Procédé de fabrication de la couche d'absorption de la cellule solaire selon la revendication 1, après l'étape de formation de la couche d'absorption (S204), comprenant en outre l'éloignement de la source de vapeur en phase solide (120, 510) de la couche d'absorption de sorte que la distance entre la source de vapeur en phase solide (120, 510) et la couche d'absorption soit plus longue que la distance prédéterminée (D) (S206).

5. Procédé de fabrication de la couche d'absorption de la cellule solaire selon la revendication 1, dans lequel la température d'effusion est supérieure à la température de vaporisation.

6. Procédé de fabrication de la couche d'absorption de la cellule solaire selon la revendication 1, dans lequel la température d'effusion est comprise entre 350 °C et 650 °C.

7. Procédé de fabrication de la couche d'absorption de la cellule solaire selon la revendication 1, dans lequel la distance prédéterminée (D) est comprise entre 0,1 cm et 4 cm.

8. Procédé de fabrication de la couche d'absorption de la cellule solaire selon la revendication 1, dans lequel la source de vapeur en phase solide (120, 510) est une source de vapeur en phase solide plane ou un réseau de sources de vapeur ponctuelles en phase solide.

9. Procédé de fabrication de la couche d'absorption de la cellule solaire selon la revendication 1, dans lequel le précurseur de couche d'absorption (30) contient en outre du sélénium, et la source de vapeur en phase solide (120, 510) et la vapeur contiennent en outre du sélénium.

10. Procédé de fabrication de la couche d'absorption de la cellule solaire selon la revendication 1, dans lequel la source de vapeur en phase solide (120, 510) et la vapeur contiennent en outre du soufre.

11. Procédé de fabrication de la couche d'absorption de la cellule solaire selon la revendication 1, dans lequel la source de vapeur en phase solide (120, 510) est du sulfure stannique, du sulfure stanneux, du séléniure stannique, du séléniure stanneux ou des combinaisons de ceux-ci.

12. Procédé de fabrication de la couche d'absorption de la cellule solaire selon la revendication 1, comprenant en outre le remplissage d'un premier gaz dans la chambre (11, 51), dans lequel le premier gaz est de la vapeur de soufre, de la vapeur de sélénium, du sulfure d'hydrogène, du séléniure d'hydrogène ou des combinaisons de ceux-ci.

13. Procédé de fabrication de la couche d'absorption de la cellule solaire selon la revendication 1, comprenant en outre le remplissage d'un deuxième gaz dans la chambre (11, 51), dans lequel le deuxième gaz est du sulfure stannique, du sulfure stanneux, du séléniure stannique, du séléniure stanneux ou des combinaisons de ceux-ci.

14. Procédé de fabrication de la couche d'absorption de la cellule solaire selon la revendication 1, dans lequel la température de vaporisation et la température de formage sont comprises entre 200 °C et 800 °C.

15. Dispositif de traitement thermique (50), utilisé pour effectuer un traitement thermique sur un précurseur de couche d'absorption (30) sur un substrat (20) d'une cellule solaire, le précurseur de couche d'absorption (30) contenant du cuivre, du zinc, de l'étain et du soufre, le dispositif de traitement thermique (50) étant **caractérisé par** :
une chambre unique (51) ayant une zone de chauffage (513), une zone de traitement thermique (514) et une zone de refroidissement (515) en séquence, la température dans la zone de chauffage (513) est défini de manière à être inférieure à la température dans la zone de traitement thermique (514), dans lequel une source de vapeur en phase solide (510) est disposée dans la zone de traitement thermique (514), et la source de vapeur en phase solide (510) contient de l'étain, et la température dans la zone de refroidissement (515) est définie de manière à être inférieure à la température dans la zone de traitement thermique (514) ;
un support mobile (52) disposé de façon mobile dans la chambre (51), où le support mobile (52) est adapté pour se déplacer de la zone de chauffage (513) vers la zone de traitement thermique (514) le long d'une première direction, et le substrat (20) est disposé sur le support mobile (52) ;
une unité d'admission de gaz (54), où l'unité d'admission de gaz (54) est adaptée pour amener un gaz dans la chambre unique (51), de sorte que le gaz se déplace dans la chambre (51) le long d'une deuxième direction, et la deuxième direction est opposée à la première direction ; et
un régulateur de température (53), assemblé à la chambre (51), où le régulateur de température (53) est adapté pour ajuster la température dans la seule chambre (51) ; dans lequel, lorsque le support mobile (52) se déplace vers la zone de traitement thermique (514), le précurseur de couche d'absorption (30) sur le substrat (20) et la source de vapeur en phase solide (510) sont maintenus à une distance prédéterminée (D).

16. Dispositif de traitement thermique (50) selon la revendication 15, dans lequel le précurseur de couche d'absorption (30) contient en outre du sélénium, et la source de vapeur en phase solide (510) contient en outre du sélénium.

17. Dispositif de traitement thermique (50) selon la revendication 15, dans lequel la source de vapeur en phase solide (510) contient en outre du soufre.

18. Dispositif de traitement thermique (50) selon la revendication 15, dans lequel la distance prédéterminée (D) est comprise entre 0,1 cm et 4 cm.

19. Dispositif de traitement thermique (50) selon la revendication 15, dans lequel la source de vapeur en phase solide (510) est une source de vapeur en phase solide plane ou un réseau de sources de vapeur ponctuelles en phase solide.

20. Dispositif de traitement thermique (50) selon la revendication 15, dans lequel la source de vapeur en phase solide (510) est du sulfure stannique, du sulfure stanneux, du séléniure stannique, du séléniure stanneux ou des combinaisons de ceux-ci.
